# EUROPEAN PATENT APPLICATION

(11) **EP 4 575 410 A1**
(43) Date of publication of application: **25.06.2025**
(21) Application number: 23218799.7
(22) Date of filing: 20.12.2023
(51) Int. Cl.: G01D 4/00, G01D 18/00

(54) **A METHOD FOR CALIBRATING AT LEAST ONE ENERGY SENSOR IN AN INDUSTRIAL ENVIRONMENT, A COMPUTER PROGRAM PRODUCT, A COMPUTER-READABLE STORAGE MEDIUM, AS WELL AS A CALIBRATING SYSTEM**

(71) Applicant: Siemens Aktiengesellschaft, 80333 München (DE)
(72) Inventor: Narayan, Charishma, 560078 Bengaluru (IN); Raab, Oliver, 94496 Ortenburg (DE); Santos Wilke, Hans, 85599 Parsdorf (DE); Weikert, Robert, 92342 Burggriesbach (DE)
(74) Representative: Siemens Patent Attorneys

(57) **Abstract**

The invention relates to a method for calibrating at least one energy sensor (26, 28, 30) in an industrial environment (10) by a calibrating system (12) of the industrial environment (10), comprising the steps of: providing at least a first energy consumption device (20) with a first energy sensor (26) and a second energy consumption device (22) with a second energy sensor (28) in the industrial environment (10), wherein the first energy consumption device (20) and the second energy consumption device (22) are connected together to an energy distribution node (32) of the industrial environment (10); capturing a global energy consumption at the energy distribution node (32) by a global energy sensor (16) of the calibrating system (12); and calibrating the first energy sensor (26) and/or the second energy sensor (28) depending on the global energy consumption by an electronic computing device (14) of the calibrating system (12). Furthermore, the invention relates to a computer program product, a computer-readable storage medium, as well as to a calibrating system (12) .

## Description

The present invention relates to a method for calibrating at least one energy sensor in an industrial environment by a calibrating system of the industrial environment according to pending claim 1. Furthermore, the present invention relates to a computer program product, to a computer-readable storage medium, as well as to a calibrating system.

Energy is at the very core of the sustainable development goals for 2030. Energy consumption streamlining in an industrial environment is a crucial factor and needs immediate attention. We are at the helm of an energy transition that has demanded urgent actions to avoid long-term catastrophic climate changes. A key contributor to aid this effort will be to ensure energy is consumed efficiently and optimally. The monitoring and management of energy consumption in production plants will become increasingly important since they have a fairly larger footprint in the energy ecosystem of the future. The reasons for this are two fold, on the one hand, there are these legal and environmental regulations, while on the other, the whopping energy costs.

Today's production plants are equipped with a large number of electrical consumers at different levels. Examples include the higher-level site supply, the supply of buildings and offices, but of course also the supply of individual production facilities, conveyor belts, furnaces, and IT systems. The supply of all these electrical consumers with energy measuring equipment requires a great deal of money, material resources and time. In the context of large companies, several 1000 measuring points per company would be needed and these cost-intensive sensors and electrical components are necessary to achieve good measurement accuracy at each of the individual measuring points. Imagine the cost and effort spent on installation for attaching the sensors/measuring points. Therefore, there is a need in a low-cost, easy to use, reliable, standardized and scalable energy measuring capability.

So far, the problem has been solved by installing expensive and precise sensors only at individual, selected points, not all. A consumption measurement at the level of individual devices is only carried out in individual cases and usually only for newly installed machines. This approach does not account for the existing machines, which obviously, consume a lot more energy and probably need to be checked frequently too, which might result in unprecedented down-times, excess energy consumption and even energy wastage/leakages.

Another approach is to temporarily install or apply precise invasive or non-invasive expensive measurement technology in order to capture a unique picture of the energy consumption of these individual points. This would then disturb the current system, adding to overheads on handling, maintenance, and training. Most large companies might not find this a sustainable, nor scalable approach.

AI (Artificial Intelligence) driven solutions are already being used in different capacities that include energy consumption prediction, pattern recognition and optimization. However, getting AI to work at the edge, on a sensing device that can manage and optimize energy consumption at production systems on an industrial scale, is nascent and exploratory.

It is an object of the present invention to provide a method, a computer program product, a computer-readable storage medium, as well as a calibrating system, by which calibrating of at least one energy sensor in the industrial environment is provided in an easy manner.

This object is solved by a method, a computer program product, a computer-readable storage medium, as well as a calibrating system according to the independent claims. Advantageous embodiments are presented in the dependent claims.

One aspect of the invention relates to a method for calibrating at least one energy sensor in an industrial environment by a calibrating system of the industrial environment. At least a first energy consumption device with a first energy sensor and a second energy consumption device with a second energy sensor in the industrial environment is provided, wherein the first energy consumption device and the second energy consumption device are connected together to an energy distribution node of the industrial environment. A global energy consumption at the energy distribution node is captured by a global energy sensor of the calibrating system. Calibrating the first energy sensor and/or the second energy sensor depending on the global energy consumption is performed by an electronic computing device of the calibrating system.

Therefore, the present invention solves the problem by installing for example so-called low-cost energy meters in the production halls/industrial environment. The measurement accuracy and calibration of the energy sensor is carried out at the overall system level. An energy measuring device is attached to, in particular, all nodes and end points. The individual energy measuring points are provided with for example time stamps or can be set in relation to each other via the wireless or wired data line. If an electric consumer is switched on, this has a repercussion on the other participants, as they are connected to the same distribution network.

In particular, feedback at the high nodes on the so-called tree in the industrial environment can be detected and measured. If a high-precision energy measuring device is now attached to the higher node, which is related to the energy distribution node, and/or only the highest node, the so-called distribution panel, a calibration or regular re-calibration of the energy sensors can be carried out on the electronic computing devices.

According to the state of the art a complex factory calibration of the energy sensors has to be carried out. Local disturbances caused by geometric inaccuracies as well as electric and magnetic fields can not be considered. The energy sensors used today require contact measurement methods for voltage measurement or they accept compromises in accuracy by a current measurement only. Contact-based measurements require partial decommissioning of product facilities, for example electrical wiring, and are associated with increased installation costs.

However, the proposed invention provide a scalability. System-level calibration greatly reduces the effort required for single-sensor calibration, in particular lower installation costs. An extension of the so-called "energy meter network" is possible at any time thanks to the non-invasive measurement method. For example, if further production lines are to be monitored or the production hall/industrial environment is to be expanded by further lines.

Furthermore, an accuracy and ease of use is provided. The accuracy of the overall system is greatly improved. Inexpensive, non-contact individual sensors can be used.

Furthermore, the invention provides intelligence operations. For example with the help of artificial intelligence (AI) algorithms, for example a neural network, the construction of a self-monitoring system is possible, on the one hand for independent recalibration but also for predictive maintenance based on energy consumption.

Furthermore, a control in governance-based system may be provided. Due to the large number of distributed sensors, maintenance, component replacement, but also changes in the use of the individual systems are immediately visible in the energy consumption and can thus be used to save energy and energy costs.

Furthermore, an energy utilization enhancement is provided. The costs that industrial companies are charged for their electricity connections also consists of the "kWp" value (kilo Watt peak) of the connected load since these short-term peak powers must also be provided by the supplier. With a large number of distributed sensors, the effect of individual system components on the kWp value of the grid connection can be determined. In an assumed case the several independent processes are carried out in a hall, an optimization of profitability can be achieved, with/without artificial intelligence, presumable purely analytical approach may also be possible. Each line has the information on energy consumption, impact on peak power (kWp) and a value that reflects the contribution of the profitability of the company. Through phase-shifted operation of individual lines, an optimal ration between kWp and yield can be regulated, the basis of which is only created by the information from the distributed sensors.

According to an embodiment a first energy consumption at the first energy consumption device is captured by the first energy sensor and/or a second energy consumption at the second energy consumption device is captured by the second energy sensor, wherein the first energy consumption and/or the second energy consumption is taken into consideration for calibrating the first energy sensor and/or the second energy sensor. For example, a comparison between the global energy consumption and the local energy consumption at the consumption devices may be used in order to tune the calibrating. In particular, for example if the electronic computing device may assume that no calibration of the energy sensors is needed, no calibration is performed by the electronic computing device. Therefore, for example a threshold value for the calibration may be used. If the comparison fails, and reaches the threshold, the calibration may be performed.

In another embodiment the capturing of the first energy consumption and/or the second energy consumption is used as a trigger-signal for the calibrating process. For example, at the first energy consumption device and the second energy consumption device an energy consumption is measured/captured. It may be used in order to trigger the global energy sensor to measure the global energy at the energy distribution node. Therefore, the electronic computing device knows that an event is happening at the first energy consumption device and/or the second energy consumption device. Therefore, a comparison can be performed by the electronic computing device.

In another embodiment a time-stamp for the first energy consumption and/or a time-stamp for the second energy consumption is taken into consideration for calibrating the first energy sensor and/or the second energy sensor. In particular, the energy measuring device may be attached to all nodes and end points. The energy measuring points are provided with the same time stamps or can be set in relation to each other via the wireless or wired data line. Therefore, an advantageous calibrating of the energy sensors may be provided.

According to another embodiment at least the first energy consumption device and/or the second energy consumption device is wirelessly connected to the electronic computing device. Therefore, an easy way for transmitting measurements is provided. In particular, calibrating system can easily be installed into an existing industrial environment.

In another embodiment an automatic calibrating of the first energy sensor and/or the second energy sensor is performed and/or a repeated calibrating of the first energy sensor and/or the second energy sensor is performed. Therefore, automatic calibration of the energy sensors may be performed, which reduces the effort necessary for calibration. Furthermore, the repeated calibrating is also advantageous, the accuracy and stability of the overall systems stays high.

In another embodiment a predefined interference signal is injected at the first energy consumption device and/or the second energy consumption device and the global energy sensor is calibrated depending on the predefined interference signal. In particular, a deliberately introduce interference signal or precisely known consumption at the individual nodes is used. These signals can be used to carry out an accuracy comparison or calibration of the installed sensors in the network above the node. To give some details, at the lowest node a resistor may be switched on. This added and known energy consumption can be measured at all higher nodes and can therefore be used as a calibration signal. Furthermore, a large number of interference signals, or precisely known consumers, is also conceivable. By connecting different consumers individually or simultaneously for the purpose of calibration, a calibration without the above-mentioned high-precision energy measuring device at the highest node is conceivable, with sufficient numbers.

In another embodiment the electronic computing device is provided with an artificial intelligence. For example, the artificial intelligence of the system learns to distinguish different consumer electrical patterns. A certain pattern is generated at a low node before. Therefore, the artificial intelligence can be used for a more precise calibrating of the electric sensors. The artificial intelligence can for example be provided as a machine learning algorithm or a neural network.

In another embodiment a specific electrical pattern of the first energy consumption device and/or the second energy consumption device is used for training the artificial intelligence and the specific electrical pattern is used as a trigger signal for the calibration. For example, a certain pattern is generated at a low node and this pattern is recognized at a higher node subsequently. Therefore, a signature can be directly related to an event and be used to calibrate the sensors. This is an important option, because it gives the opportunity to distinguish between the intended known consumer or if two consumers were switched on at the same time and their signatures are superimposed.

In another embodiment a point in time for performing the calibration is determined by the artificial intelligence. By applying the artificial intelligence algorithm the opportunity to detect when it is the appropriate time for calibrating the system is used. The system may learn, for example, how the typical pattern of starting a machine looks like. After learning that behavior, it can use a specific point in time in order to calibrate the sensors.

In another embodiment the calibration is performed during an idle mode of the first energy consumption device and/or the second energy consumption device. For example, the typical pattern of starting the machine/energy consumption device looks like: close safety door, turn on signal lights, start motor, run motor, stop motor, turn into low power idle mode. After learning that behavior, it can use the low power idle mode to do the calibration of the sensors. Without having the interference of an unplanned power consumption state of the machine.

In another embodiment after calibrating of the at least one energy sensor the industrial environment is monitored by the at least one calibrated sensor. By monitoring the individual components and machines, deviations and anomalies in consumption behavior are detected and for example warning signals can be issued. Therefore, a precise monitoring of the industrial environment is provided.

In particular, the provided method is a computer-implemented method. Therefore, another aspect of the invention relates to a computer program product comprising program code means for performing the method according to the preceding aspect.

A still further aspect of the invention relates to a computer-readable storage medium comprising at least the computer program product according to the preceding aspect.

Furthermore, the present invention relates to a calibrating system for calibrating at least one energy sensor in an industrial environment, comprising at least one electronic computing device and one global energy sensor, wherein the calibrating system is configured for performing a method according to the preceding aspect. In particular, the method is performed by the calibrating system.

Furthermore, the present invention relates to an industrial environment comprising at least the calibrating system according to the preceding aspect and at least one first energy consumption device and a second energy consumption device.

Advantageous embodiments of the method are to be regarded as advantageous embodiments of the computer program product, the computer-readable storage medium, the calibrating system as well as the industrial environment. The industrial environment as well as the calibrating system therefore comprises means for performing the method.

An artificial neural network can be understood as a software code or a compilation of several software code components, wherein the software code may comprise several software modules for different functions, for example one or more encoder modules and one or more decoder modules.

An artificial neural network can be understood as a non-linear model or algorithm that maps an input to an output, wherein the input is given by an input feature vector or an input sequence and the output may be an output category for a classification task or a predicted sequence.

For example, the artificial neural network may be provided in a computer-readable way, for example, stored on a storage medium of the vehicle, in particular of the at least one computing unit.

The neural network comprises several modules including the encoder module and the at least one decoder module. These modules may be understood as software modules or respective parts of the neural network. A software module may be understood as software code functionally connected and combined to a unit. A software module may comprise or implement several processing steps and/or data structures.

The modules may, in particular, represent neural networks or sub-networks themselves. If not stated otherwise, a module of the neural network may be understood as a trainable and, in particular, trained module of the neural network. For example, the neural network and thus all of its trainable modules may be trained in an end-to-end fashion before the method is carried out. However, in other implementations, different modules may be trained or pre-trained individually. In other words, the method according to the invention corresponds to a deployment phase of the neural network.

A computing unit/electronic computing device may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

For use cases or use situations which may arise in a method according to the invention and which are not explicitly described herein, it may be provided that, in accordance with the method, an error message and/or a prompt for user feedback is output and/or a default setting and/or a predetermined initial state is set.

Independent of the grammatical term usage, individuals with male, female or other gender identities are included within the term.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

The drawings show in:

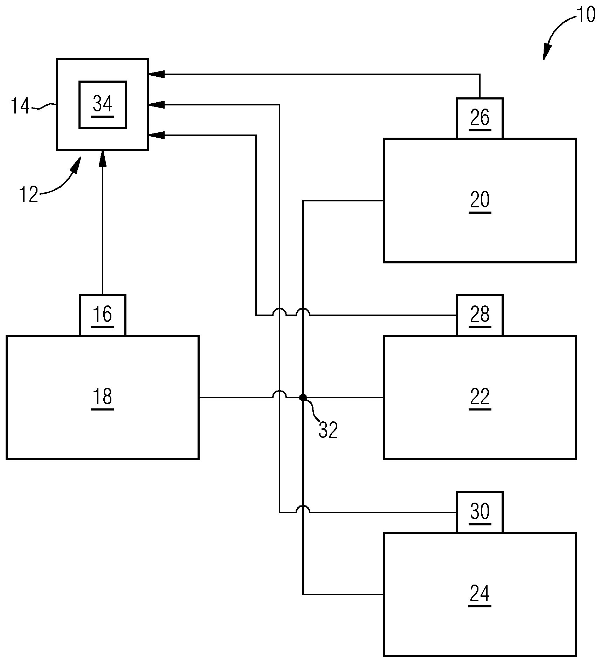

- FIG 1: a schematic block diagram according to an embodiment of an industrial environment comprising an embodiment of a calibrating system.

In the figure the same elements are comprising the same reference signs.

FIG 1 shows a schematic block diagram according to an embodiment of an industrial environment 10 comprising a calibrating system 12. The calibrating system 12 comprises at least one electronic computing device 14 as well as one global energy sensor 16.

Furthermore, the present FIG 1 shows for example a so-called distribution panel 18. Furthermore, a first energy consumption device 20, a second energy consumption device 22 and a third energy consumption device 24 is shown. It is obvious for a person skilled in the art, that a different structure of the industrial environment 10 may be provided, for example with more energy consumption devices 20, 22, 24 and also in another structure as shown.

The first energy consumption device 20 comprises a first energy sensor 26. The second energy consumption device 22 comprise a second energy sensor 28. The third energy consumption device 24 comprises a third energy sensor 30. The first energy sensor 26, the second energy sensor 28 and the third energy sensor 30 are connected to the electronic computing device 14. Furthermore, the global energy sensor 16 is connected to the electronic computing device 14.

According to an embodiment at least the first energy consumption device 20 with the first energy sensor 26 and the second energy consumption device 22 with the second energy sensor 28 is provided in the industrial environment 10, wherein the first energy consumption device 20 and the second energy consumption device 22 are connected together through an energy distribution node 32. The energy distribution node 32 in this embodiment is connected to the distribution panel 18. A global energy consumption at the energy distribution node 32 is captured by the global energy sensor 16 of the calibrating system 12. The first energy sensor 26 and/or the second energy sensor 28 is calibrated depending on the global energy consumption by the electronic computing device 14. In particular, in the shown embodiment, also the third energy sensor 30 may be calibrated by the electronic computing device 14.

In particular, a first energy consumption at the first energy consumption device 20 is captured by the first energy sensor 26 and/or a second energy consumption at the second energy consumption device 22 is captured by the second energy sensor 28, wherein the first energy consumption and/or the second energy consumption is taken into consideration for calibrating the first energy sensor 26 and/or the second energy sensor 28.

Furthermore, a time-stamp for the first energy consumption and/or a time-stamp for the second energy consumption is taken into consideration for calibrating the first energy sensor 26 and/or the second energy sensor 28. At least the first energy sensor 26 and/or the second energy sensor 28 may be for example wirelessly connected to the electronic computing device 14. Furthermore, an automatic calibrating of the first energy sensor 26 and/or the second energy sensor 28 is performed and/or a repeated calibrating of the first energy sensor 26 and/or the second energy sensor 28 is performed.

In another embodiment a predefined interference signal is injected at the first energy consumption device 20 and/or the second energy consumption device 22 and the global energy sensor 16 is calibrated depending on the predefined interference signal.

Furthermore, the electronic computing device 14 is provided with an artificial intelligence 34. A specific electrical pattern of the first energy consumption device 20 and/or the second energy consumption device 22 may be used for training the artificial intelligence 34 and the specific electrical pattern is used as a trigger signal for the calibration. Furthermore, a point in time for performing the calibration is determined by the artificial intelligence 34. Furthermore, the calibration is performed during an idle mode of the first energy consumption device 20 and/or the second energy consumption device 22.

Therefore, the present invention solves the problem by installing many low-cost "(wireless) energy meters" in the production halls/industrial environment 10. The measurement accuracy and calibration of the energy sensors 26, 28, 30 is carried out at the overall system level. Figure 1 shows the schematic structure of a production. The usual flow of energy takes place from left to right. In the future, however, it would also be conceivable that energy feed-in takes place at machine level (i.e. right or center).

An energy sensor 26, 28, 30 is, in particular, attached to all nodes and end points. The individual energy measuring points are provided with time stamps or can be set in relation to each other via the wireless or wired data line. If an electrical consumer/energy consumption device 20 ,22, 24 is switched on at the far right of the FIG 1, this has a repercussion on the other participants, as they are connected to the same distribution network. In particular, the feedback at the higher nodes on the tree (left in the FIG 1) can be detected and measured. If a high-precision energy measuring device is now attached to the higher node, in particular the energy distribution node 32, and/or only to the highest node, the distribution panel 18, a calibration or regular re-calibration of the energy sensors 26, 28, 30 can be carried out on the consumers.

Another possibility would be to deliberately introduce interference signals or precisely known consumption at individual nodes. These signals can be used to carry out an accuracy comparison or calibration of the installed energy sensors 26, 28, 30 in the network above the node. To give some details, at the lowest node a resistor is switched on. This added and known energy consumption can be measured at all higher nodes and can therefore be used as calibration signal.

A large number of interfering signals, or precisely known consumers, is also conceivable. By connecting different consumers individually or simultaneously for the purpose of calibration, calibration without the above-mentioned high-precision energy measuring device at the highest node is conceivable - with sufficient numbers.

A further level of expansion could be that by means of artificial intelligence the system learns to distinguish different consumer electrical patterns. A certain pattern is generated at a low node and this pattern is recognized at a higher node subsequently. Therefore, the signature can be directly related to an event and be used to calibrate the energy sensors 26, 28, 30. This is an important option as well because, it gives the opportunity to distinguish between the intended known consumer or if two consumers were switched on at the same time and their signatures are superimposed.

Applying AI-algorithms also gives the opportunity to detect when it is the appropriate time for calibrating the system. The system learns, for example, how the typical pattern of starting a machine looks alike (e.g. close safety door, turn on signal lights, start motor, run motor, stop motor, turn into low power idle mode). After learning that behavior, it can use the low power idle mode to do the calibration of the energy sensor 26, 28, 30, without having the interference of an unplanned power consumption state of the machine.

Another possibility or expansion stage is to build a self-learning system of energy sensors 26, 28, 30 with the help of artificial intelligence algorithms. The energy sensors 26, 28, 30 may monitor each other and recalibrate each other if necessary. Approaches like Reinforcement learning which tend to optimize energy consumption based on certain set points may be a good starting point. Since the entire network can be controlled, optimization across various points which have higher consumption vs those which have a lower consumption can be achieved.

Another perspective is that each individual consumer connected to the network generates a specific consumption pattern on the power lines. These consumption patterns can span across the system, over time, at crucial points and even throughout a specific process/operation of the production system. A self-learning system can recognize, store and relate them to each other. By monitoring the individual components and machines, deviations and anomalies in consumption behavior are detected and warnings (predictive maintenance) can be issued. With a known consumption pattern, the energy sensors 26, 28, 30 can recalibrate themselves in a self-learning system. The precision of the calibration increases with the number or density of energy sensors 26, 28, 30 used. The result thereby, is an intelligent system of energy consumption sensors which can provide pre-emptive insight into consumption, allow for corrections (where required) and assess in real-time, consumption fluctuations, so that the system can be optimized. This will bring down the energy consumption considerably because there is now a way to assess and sense where the max energy is being used, and whether this is intended or is indeed an anomaly.

Another point is that by building a trained network, experience can be gained as to which points of the network further need re-consideration in way that an "accurate" measuring equipment should be added in order to improve the overall measurement performance. It can also be used to assess, at which points measuring devices can be omitted without compromising the overall accuracy.

### Reference signs

- 10: Industrial environment
- 12: Calibrating system
- 14: Electronic computing device
- 16: Global energy sensor
- 18: Distribution panel
- 20: First energy consumption device
- 22: Second energy consumption device
- 24: Third energy consumption device
- 26: First energy sensor
- 28: Second energy sensor
- 30: Third energy sensor
- 32: Energy distribution node
- 34: Artificial intelligence

## Claims

1. A method for calibrating at least one energy sensor (26, 28, 30) in an industrial environment (10) by a calibrating system (12) of the industrial environment (10), comprising the steps of:
- providing at least a first energy consumption device (20) with a first energy sensor (26) and a second energy consumption device (22) with a second energy sensor (28) in the industrial environment (10), wherein the first energy consumption device (20) and the second energy consumption device (22) are connected together to an energy distribution node (32) of the industrial environment (10);
- capturing a global energy consumption at the energy distribution node (32) by a global energy sensor (16) of the calibrating system (12); and
- calibrating the first energy sensor (26) and/or the second energy sensor (28) depending on the global energy consumption by an electronic computing device (14) of the calibrating system (12).

2. A method according to claim 1, wherein
a first energy consumption at the first energy consumption device (20) is captured by the first energy sensor (26) and/or a second energy consumption at the second energy consumption device (22) is captured by the second energy sensor (28), wherein the first energy consumption and/or the second energy consumption is taken into consideration for calibrating the first energy sensor (26) and/or the second energy sensor (28).

3. A method according to claim 2, wherein
the capturing of the first energy consumption and/or the second energy consumption is used as a trigger-signal for the calibrating process.

4. A method according to claim 2 or 3, wherein
a time-stamp for the first energy consumption and/or a time-stamp for the second energy consumption is taken into consideration for calibrating the first energy sensor (26) and/or the second energy sensor (28).

5. A method according to any one of claims 1 to 4, wherein
at least the first energy sensor (26) and/or the second energy sensor (28) is wirelessly connected to the electronic computing device (14).

6. A method according to any one of claims 1 to 5, wherein an automatic calibrating of the first energy sensor (26) and/or the second energy sensor (28) is performed and/or a repeated calibrating of the first energy sensor (26) and/or the second energy sensor (28) is performed.

7. A method according to any one of claims 1 to 6, wherein
a predefined interference signal is injected at the first energy consumption device (20) and/or the second energy consumption device (22) and the global energy sensor (16) is calibrated depending on the predefined interference signal.

8. A method according to any one of claims 1 to 7, wherein the electronic computing device (14) is provided with an artificial intelligence (34).

9. A method according to claim 8, wherein
a specific electrical pattern of the first energy consumption device (20) and/or the second energy consumption device (22) is used for training the artificial intelligence (34) and the specific electrical pattern is used as trigger signal for the calibration.

10. A method according to claim 8 or 9, wherein
a point in time for performing the calibration is determined by the artificial intelligence (34).

11. A method according to any one of claims 8 to 10, wherein the calibration is performed during an idle mode of the first energy consumption device (20) and/or the second energy consumption device (22).

12. A method according to any one of claims 8 to 10, wherein after calibration of the at least one energy sensor (26, 28, 30) the industrial environment (10) is monitored by the at least one calibrated energy sensor (26, 28, 30).

13. A computer program product comprising program code means for performing a method according to any one of claims 1 to 12.

14. A computer-readable storage medium comprising at least one computer program product according to claim 13.

15. A calibrating system (12) for calibrating at least one energy sensor (26, 28, 30) in an industrial environment (10), comprising at least one electronic computing device (14) and one global energy sensor (16), wherein the calibrating system (12) is configured for performing a method according to any one of claims 1 to 12.
